# EUROPEAN PATENT APPLICATION

(11) **EP 4 703 841 A1**
(43) Date of publication of application: **04.03.2026**
(21) Application number: 25196272.6
(22) Date of filing: 15.08.2025
(51) Int. Cl.: G05F 3/26, G05F 3/30, H01B 12/00

(54) **SEMICONDUCTOR DEVICE**

(30) Priority: 27.08.2024 KR 20240115372; 18.10.2024 KR 20240143265
(71) Applicant: Samsung Electronics Co., Ltd., Suwon-si, Gyeonggi-do 16677 (KR)
(72) Inventor: CHOI, Haejung, 16677 Suwon-si (KR); KIM, Jooseong, 16677 Suwon-si (KR); PARK, Himchan, 16677 Suwon-si (KR); YANG, Junhyeok, 16677 Suwon-si (KR); YOO, Sungmin, 16677 Suwon-si (KR); CHOI, Michael, 16677 Suwon-si (KR)
(74) Representative: Marks & Clerk LLP

(57) **Abstract**

A semiconductor device includes a first die manufactured under first process conditions and a second die manufactured under second process conditions. The first die includes a reference generation circuit including a bipolar junction transistor (BJT) element. The second die is configured to operate based on a reference value generated by the reference generation circuit. The first process conditions are different from the second process conditions.

## Description

### BACKGROUND

Some example embodiments relate to a semiconductor device. More particularly, some example embodiments relate to a semiconductor device including dies having different process conditions and/or structures.

In general, semiconductor devices may generate internal voltages of various levels by receiving external power and may operate internal circuits using the internal voltages. To this end, the generation of a precise reference current or reference voltage is desirable.

A circuit for generating a precise reference current or reference voltage may include a bipolar junction transistor (BJT) element. However, it may be difficult to use BJT elements in all processes, and it may be impossible or difficult to use BJT elements in more or highly integrated or miniaturized advanced processes.

### SUMMARY

Some example embodiments provide a semiconductor device in which a die having miniaturized or more highly integrated process conditions may obtain more precise reference current and/or voltage values and may operate based on the more precise reference current and/or voltage values.

According to some example embodiments, there is provided a semiconductor device.

The semiconductor device includes a first die having a first structure and a second die manufactured having a second structure, wherein the first die includes a reference generation circuit including a bipolar junction transistor (BJT) element, the second die is configured to operate based on a reference value generated by the reference generation circuit, and the first structure is different from the second structure.

Alternatively or additionally according to some example embodiments, there is provided a semiconductor device. The semiconductor device may include a first die and a second die stacked in a vertical direction, wherein the first die includes a reference generation circuit including a BJT element, the second die is configured to operate based on a reference value generated by the reference generation circuit, and the second die is a die having a transistor with a line width of less than 3 nm.

Alternatively or additionally according to some example embodiments, there is provided a semiconductor device. The semiconductor device may include a first die and a second die arranged in a horizontal direction, wherein the first die includes a reference generation circuit including a BJT element, the second die is configured to operate based on a reference value generated by the reference generation circuit, the second die is a die having a transistor with a line width of less than 3 nm, and the first die and the second die are arranged on an interposer layer.

Additionally or alternatively according to some example embodiments, there is provided a semiconductor device including a first die and a second die that are arranged in a horizontal direction, wherein the first die comprises a reference generation circuit comprising a bipolar junction transistor (BJT) element, the second die is configured to operate based on a reference value generated by the reference generation circuit, the second die does not include a BJT element, and the first die and the second die are arranged on an interposer layer,

Alternatively or additionally according to some example embodiments, there is provided a method of operating a semiconductor device that includes a first die and a second die, the method comprising: generating at a first reference current or a first reference voltage in the first die; providing the first reference current or the first reference voltage to the second die through a channel that connects the first die with the second die; and operating the second die based on the first reference current or the reference voltage,

The method may further include converting the first reference current to a second reference voltage; and operating the second die based on the second reference voltage.

The generating the first reference current or a first reference voltage may include generating the first reference current or the first reference voltage with a bipolar junction transistor included in the first die.

The second die may not include a bipolar junction transistor.

At least some of the above and other features of the invention are set out in the claims.

### BRIEF DESCRIPTION OF THE DRAWINGS

Some example embodiments will be more clearly understood from the following detailed description taken in conjunction with the accompanying drawings in which:
FIG. 1 is a block diagram illustrating a device including a first die and a second die according to some example embodiments;
FIG. 2A is a block diagram illustrating an example of a device including a first die and a second die according to some example embodiments;
FIG. 2B is a block diagram illustrating an example of a device including a first die and a second die according to some example embodiments;
FIG. 3 is a diagram illustrating an effect of differences between first and second process conditions;
FIG. 4 is a cross-sectional diagram illustrating differences between first and second process conditions;
FIG. 5 is a circuit diagram illustrating an example of a device including a first die and a second die according to some example embodiments;
FIG. 6 is a circuit diagram illustrating an example of a device including a first die and a second die according to some example embodiments;
FIG. 7A is a schematic diagram illustrating a die arrangement structure according to some example embodiments;
FIG. 7B is a block diagram illustrating a 3D device structure to which the die arrangement structure shown in FIG. 7A is applied;
FIG. 8A is a schematic diagram illustrating a die arrangement structure according to some example embodiments;
FIG. 8B is a block diagram illustrating a 2.5D device structure to which the die arrangement structure shown in FIG. 8A is applied;
FIG. 8C is a structural diagram illustrating an example of a semiconductor package to which the 2.5D device structure shown in FIG. 8B is applied;
FIGS. 9A and 9B are diagrams illustrating embodiments in which first and second dies are applied to the 3D device structure shown in FIG. 7B;
FIGS. 10A and 10B are diagrams illustrating embodiments in which first and second dies are applied to the 3D device structure shown in FIG. 7B;
FIGS. 11A and 11B are diagrams illustrating embodiments in which first and second dies are applied to the 2.5D device structure shown in FIG. 8B;
FIG. 12 is a flowchart illustrating a method of providing a reference value, according to some example embodiments;
FIG. 13 is a flowchart illustrating a method of providing a reference current value, according to some example embodiments; and
FIG. 14 is a flowchart illustrating a method of providing a reference voltage value, according to some example embodiments.

### DETAILED DESCRIPTION OF SOME EXAMPLE EMBODIMENTS

Hereinafter, various embodiments will be described with reference to the accompanying drawings.

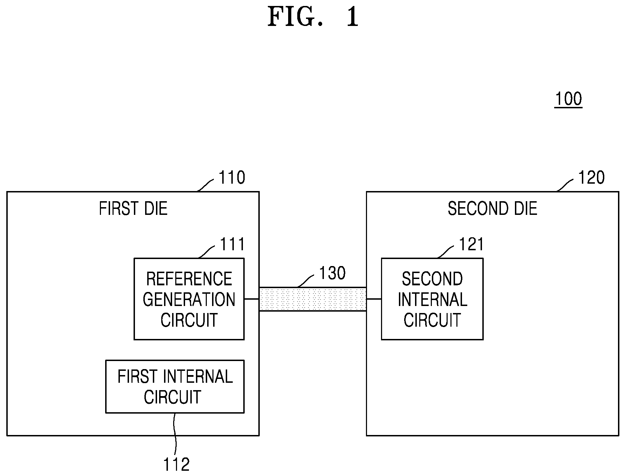

FIG. 1 is a block diagram illustrating a device including a first die and a second die according to some example embodiments.

Referring to FIG. 1, a semiconductor device 100 may include a first die 110 and a second die 120. In some example embodiments, the semiconductor device 100 may be a semiconductor chip including a plurality of dies. In another example, the semiconductor device 100 may be a semiconductor package circuit including a plurality of dies.

In some example embodiments, the first die 110 and the second die 120 may have the same size or different sizes (e.g., the same or different length and/or width) from each other. Each of the first die 110 and the second die 120 may include at least one integrated circuit. The integrated circuits included in the first die 110 and the second die 120 may include a plurality of circuit elements. In some example embodiments, the integrated circuit included in the first die 110 may be manufactured under first process conditions. In some example embodiments, the integrated circuit included in the second die 120 may be manufactured under second process conditions. For example, the integrated circuits included in the first die 110 and the second die 120 may be manufactured under different process conditions such as a bipolar junction transistor (BJT) process condition and a complementary metal oxide semiconductor (CMOS) process condition, and different processes may be used to manufacture the integrated circuits included in the first die 110 and the second die 120.

In some example embodiments, the first die 110 may include a structure having characteristics, e.g., physical characteristics, unique to the first process condition that the second die 120 does not have, and the second die 120 may have a structure having characteristics, e.g., physical characteristics, that the first die 110 does not have.

In some example embodiments, the first die 110 may be a die including an integrated circuit manufactured in a mature process. In some example embodiments, the first die 110 may be a die including an integrated circuit manufactured in a legacy process. In some example embodiments, the second die 120 may be a die including an integrated circuit manufactured in an advanced process. In some example embodiments, the second die 120 may be a die including an integrated circuit manufactured in a process of manufacturing transistors having a line width of less, e.g., a gate line width of, than 3 nm. Alternatively or additionally in some example embodiments, the second die 120 may be a die including an integrated circuit manufactured in a process of manufacturing gate-all-around (GAA) transistors having a line width of less than 3 nm. Alternatively or additionally in some example embodiments, the second die 120 may be a die including an integrated circuit manufactured in a back side power delivery network (BSPDN) process. However, example embodiments are not limited thereto. For example, the second die 120 may be a die including an integrated circuit manufactured in a miniaturized process, which is distinguishable from a legacy process in which the first die 110 may be manufactured. As described herein, first process conditions may refer to conditions of a legacy process, for example a process that does not include a fabrication technique having transistors with transistor line widths less than 3 nm or having a GAA transistor, and second process conditions may refer to conditions of a miniaturized process such as a process of manufacturing transistors having a line width of less than 3 nm. As described herein, the expression "second process conditions" may be interchangeable with expressions such as "miniaturization process" and "miniaturized process."

Referring to FIG. 1, the first die 110 may include a reference generation circuit 111 and a first internal circuit 112. The second die 120 may include a second internal circuit 121. The first internal circuit 112 may be or may include an intellectual property (IP) core or block, such as but not limited to a standard cell, implemented within the integrated circuit of the first die 110 to perform specific operations. The second internal circuit 121 may be IP core or block implemented within the integrated circuit of the second die 120 to perform specific operations.

The reference generation circuit 111 may generate reference values required for or used during operations of the first internal circuit 112 and the second internal circuit 121. In some example embodiments, the reference values may include a reference voltage or a reference current. In some example embodiments, the reference generation circuit 111 may include a band gap reference (BGR) circuit. The BGR circuit may generate a constant voltage independent of one or more of power supply voltage variations, temperature variations, or the like. For example, the BGR circuit may generate, based on a voltage proportional to temperature and a voltage inversely proportional to temperature, a constant voltage unaffected by temperature variations. In some example embodiments, the BGR circuit may include a bipolar junction transistor (BJT).

The semiconductor device 100 may further include a bus or a connection or a wiring or a channel 130 connecting the first die 110 and the second die 120 to each other. In some example embodiments, a reference value generated by the reference generation circuit 111 of the first die 110 may be provided to the second internal circuit 121 of the second die 120 through the channel 130. The first internal circuit 112 of the first die 110 may be electrically connected to the reference generation circuit 111 of the first die 110 to receive the reference value. In some example embodiments, the channel 130 connecting the first die 110 and the second die 120 to each other may be one of a through-silicon via (TSV) and an interposer layer, depending on a package structure formed by the first die 110 and the second die 120. However, the channel 130 is not limited thereto and may alternatively or additionally be provided having various structures capable of providing data between different dies.

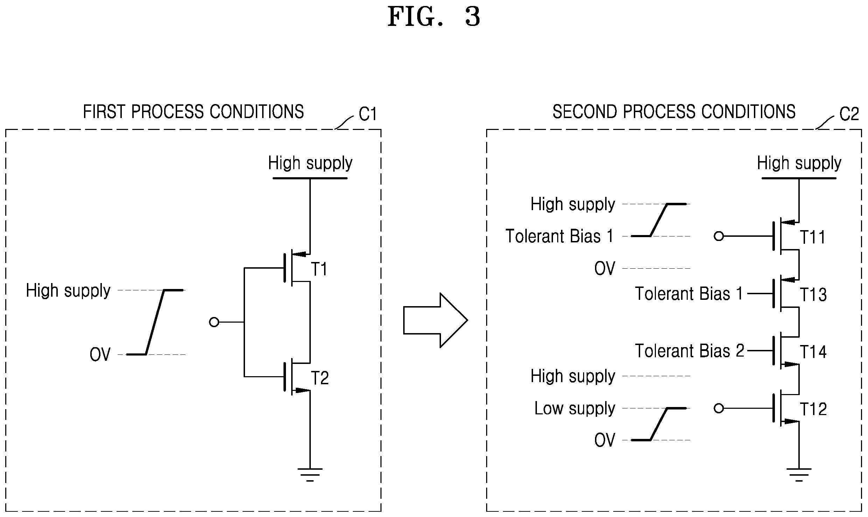

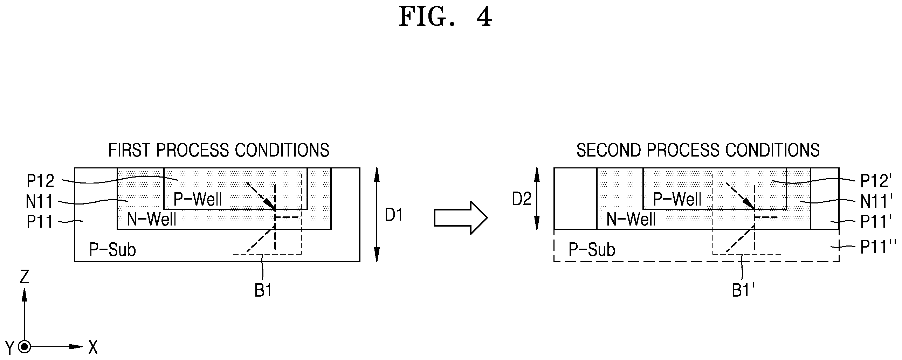

Although a circuit capable of generating reference voltage and reference current is required for (or used for) stable operations of a die including an integrated circuit, it may be difficult to design a reference voltage/current generation circuit in the second die 120 having process conditions different from legacy process conditions of the first die 110. This is further described below with reference to FIGS. 3 and 4.

In some example embodiments, the reference generation circuit 111 may include a BJT element. When the BJT element is applied to an advanced process in which semiconductor process miniaturization is implemented, process variations related to the BJT may occur. For example, process variations may change the current characteristics of the BJT element (for example, emitter current characteristics), and thus, the precision of reference voltage may decrease. According to some example embodiments, the reference generation circuit 111 including the BJT element is formed in the first die 110 having legacy process conditions, and thus, a highly precise or more precise reference value may be generated. Alternatively or additionally, because the reference generation circuit 111 including the BJT element is implemented in the first die 110 having legacy process conditions, circuit complexity may decrease, and thus, the area and/or the design costs of the second die 120 having advanced process conditions may decrease.

According to some example embodiments, the semiconductor device 100 includes the reference generation circuit 111 in one of, e.g., only one of, the first die 110 and the second die 120 that respectively include integrated circuits manufactured under different process conditions, and reference values generated by the reference generation circuit 111 may be provided to the rest of the first die 110 and the second die 120. Therefore, even a die with process conditions that make implementing a reference generation circuit in the die difficult may receive highly precise reference values. The semiconductor device 100 may be applied to all devices requiring or utilizing reference voltage/current generation circuits among 3-nm or smaller process products.

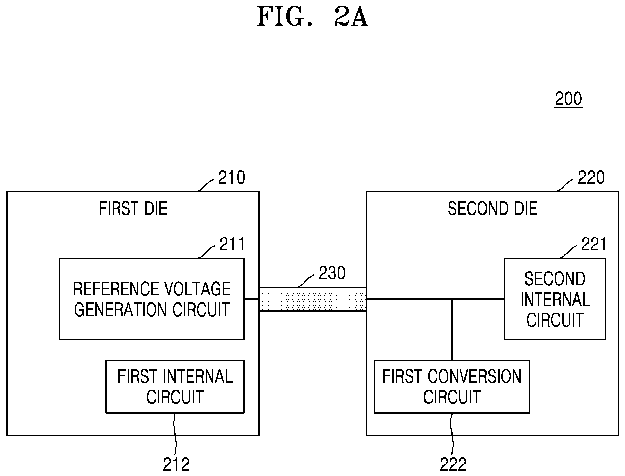

FIG. 2A is a block diagram illustrating an example of a device including a first die and a second die according to some example embodiments.

FIG. 2A is a block diagram illustrating a semiconductor device 200 including a first die 210 and a second die 220. The first die 210 may include a reference voltage generation circuit 211 and a first internal circuit 212, and the second die 220 may include a second internal circuit 221 and a first conversion circuit 222. The semiconductor device 200 may further include a wiring or channel 230 connecting the first die 210 and the second die 220 to each other. In some example embodiments, the configuration of the first die 210, the second die 220, and the channel 230 shown in FIG. 2A corresponds to the configuration of the first die 110, the second die 120, and the channel 130 shown in FIG. 1. Thus, redundant descriptions of overlapping components are omitted.

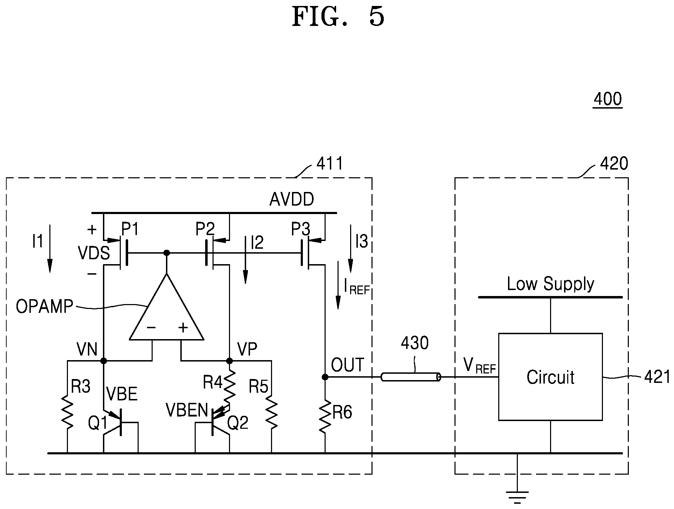

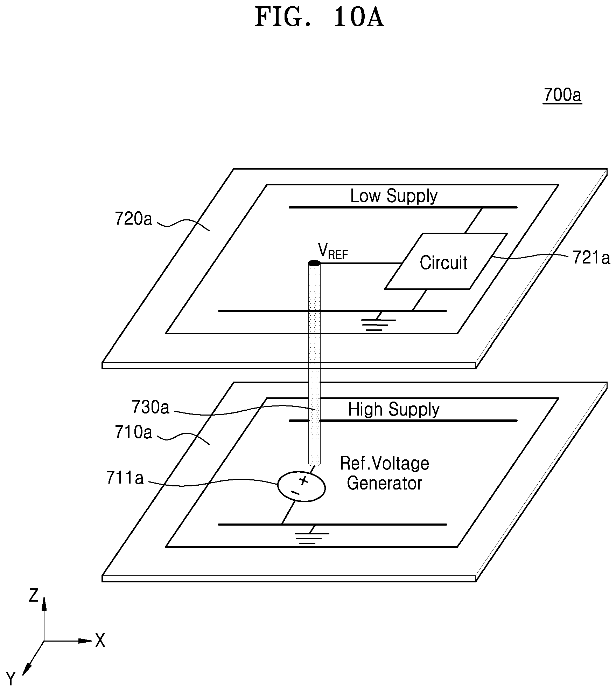

Referring to FIG. 2A, the first die 210 may include the reference voltage generation circuit 211 as a component corresponding to the reference generation circuit 111 shown in FIG. 1. In some example embodiments, the reference voltage generation circuit 211 may generate a reference voltage and may provide the reference voltage to the second internal circuit 221 of the second die 220 through the channel 230. In some example embodiments, the first conversion circuit 222 may be connected between the channel 230 and the second internal circuit 221. The first conversion circuit 222 may convert the reference voltage provided through the channel 230 into a reference current. In some example embodiments, when the second internal circuit 221 requires or utilizes a reference voltage, the second internal circuit 221 may operate based on the reference voltage provided via the channel 230. Alternatively or additionally, when the second internal circuit 221 requires or uses a reference current, the reference voltage provided through the channel 230 may be converted into a reference current by the first conversion circuit 222, and the second internal circuit 221 may operate based on the reference current. In some example embodiments, the first conversion circuit 222 may include a voltage-to-current (V-I) converter. This is further described below with reference to drawings such as FIGS. 5 and 10A.

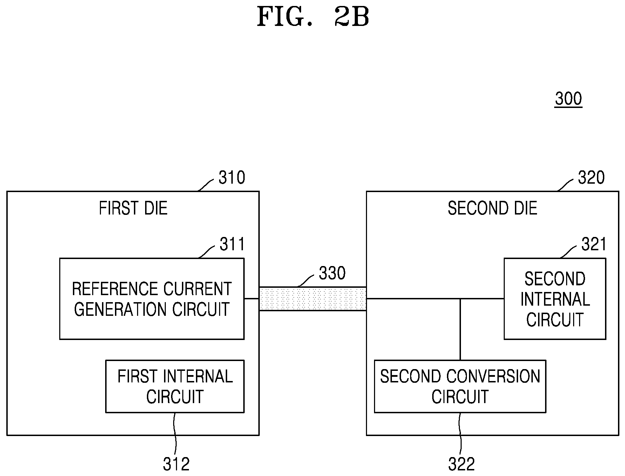

FIG. 2B is a block diagram illustrating an example of a device including a first die and a second die according to some example embodiments.

FIG. 2B is a block diagram illustrating a semiconductor device 300 including a first die 310 and a second die 320. The first die 310 may include a reference current generation circuit 311 and a first internal circuit 312, and the second die 320 may include a second internal circuit 321 and a second conversion circuit 322. The semiconductor device 300 may further include a wiring or channel 330 connecting the first die 310 and the second die 320 to each other. In some example embodiments, the configuration of the first die 310, the second die 320, and the channel 330 shown in FIG. 2B corresponds to the configuration of the first die 110, the second die 120, and the channel 130 shown in FIG. 1. Therefore, redundant descriptions of overlapping components are omitted.

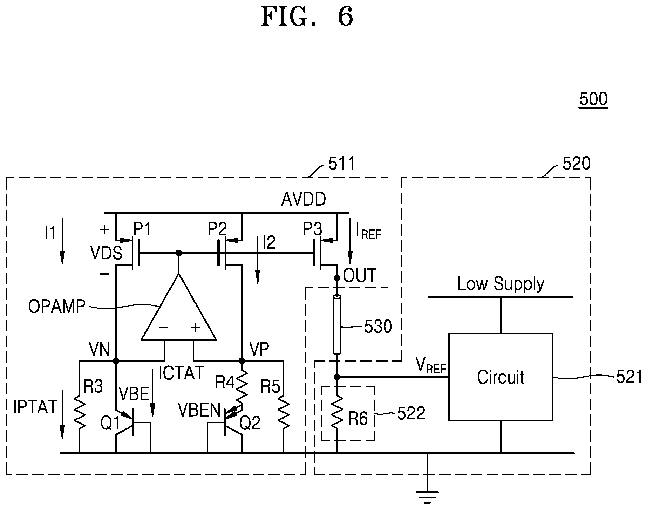

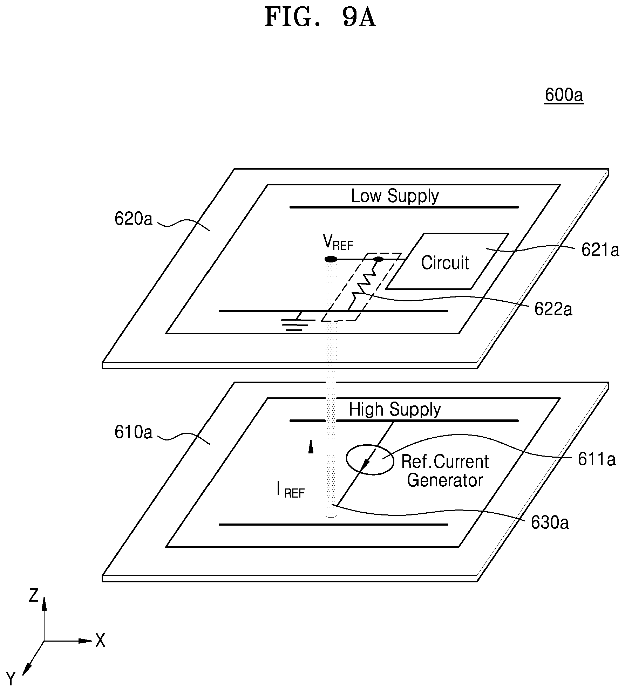

Referring to FIG. 2B, the first die 310 may include the reference current generation circuit 311 as a component corresponding to the reference generation circuit 111 shown in FIG. 1. In some example embodiments, the reference current generation circuit 311 may generate a reference current and provide the reference current to the second internal circuit 321 of the second die 320 via the channel 330. In some example embodiments, the second conversion circuit 322 may be connected between the channel 330 and the second internal circuit 321. The second conversion circuit 322 may convert the reference current provided through the channel 330 into a reference voltage. In some example embodiments, when the second internal circuit 321 requires or uses a reference current, the second internal circuit 321 may operate based on the reference current converted via the channel 330. Alternatively or additionally, when the second internal circuit 321 requires or uses a reference voltage, the reference current provided through the channel 330 may be converted into a reference voltage by the second conversion circuit 322, and the second internal circuit 321 may operate based on the reference voltage. In some example embodiments, the second conversion circuit 322 may include a resistor. This is further described below with reference to drawings such as FIGS. 6 and 9A.

Referring to some example embodiments shown in FIGS. 2A and 2B, within the same semiconductor device, a reference current and/or a reference voltage may be generated by a first die having first process conditions and may be provided to a second die having second process conditions. Owing to this structure, highly precise reference currents and/or reference voltages may be generated using a BJT element, and reference currents and/or reference voltages may be generated using a verified BGR circuit, thereby ensuring or helping to ensure the yield of and/or the reliability of products.

In some example embodiments, whether the second internal circuits 221 and 321 require or use a reference current or a reference voltage may be determined depending on operating conditions or characteristics of the second internal circuits 221 and 321. In some example embodiments, reference voltage may be required for or used for operations of a TEM sensor (temperature sensor).

FIG. 3 is a diagram illustrating differences between first and second process conditions.

FIG. 3 illustrates a first circuit C1 designed under the first process conditions and a second circuit C2 designed under the second process conditions.

In some example embodiments, the first circuit C1 may be a circuit designed for a legacy process, and the second circuit C2 may be a circuit designed for an advanced process such as a process of manufacturing transistors having a line width of less than 3 nm.

For example, a circuit for generating precise reference voltage and reference current may use a BJT element and may operate with a high voltage greater than or equal to 1.2 V. However, in miniaturized processes other than legacy processes, only low-breakdown-voltage transistors designed for digital applications may be usable, and thus, when the first circuit C1 designed for the first process conditions is implemented under the second process conditions, tolerant design techniques may be used as shown with the second circuit C2. For example, circuits even having the same function may be differently designed depending on process conditions, as shown with the first circuit C1 and the second circuit C2.

The second circuit C2 includes four transistors (four CMOS transistors) T11, T12, T13 and T14 and is thus more complex than the first circuit C1 including only two transistors (two CMOS transistors) T1 and T2. The first circuit C1 is or includes an inverter circuit with an n-channel metal-oxide-semiconductor (NMOS) transistor and a p-channel metal-oxide-semiconductor (PMOS) transistor. However, redesigning the first circuit C1 with tolerant design techniques may add bias transistors (such as the transistors T13 and T14), a voltage generation circuit for biasing, and a level shifter for converting input signals to a tolerant bias-to-supply level. As a result, when designing the same circuit under the first process conditions corresponding to a legacy process and the second process conditions corresponding to a miniaturized process, the complexity, area, and power consumption of the circuit increase in the case of designing under the second process conditions.

According to some example embodiments, reference generation circuits for generating reference voltage or current may be designed under the first process conditions, which do not require or utilize tolerant design techniques, rather than under the second process conditions, thereby reducing circuit complexity. Alternatively or additionally, because provided reference voltage is independent of supply voltage, the supply voltage and power consumption of a second die having the second process conditions may be reduced.

FIG. 4 is a cross-sectional diagram illustrating differences between first and second process conditions.

FIG. 4 illustrates a cross-sectional diagram of an integrated circuit included in a first die having the first process conditions and a cross-sectional diagram of an integrated circuit included in a second die having the second process conditions.

Referring to the cross-sectional diagram of the integrated circuit of the first die having the first process conditions, the integrated circuit may include a first substrate P11, an n-type well region N11 may be formed in the first substrate P11, and a p-type well region P12 may be formed in the n-type well region N11. In some example embodiments, a BJT element may be required to or used to implement a precise reference voltage and current circuit. Referring to FIG. 4, a BJT element B1 may be formed in the first substrate P11, the n-type well region N11, and the p-type well region P12.

Referring to the cross-sectional diagram of the integrated circuit included in the second die having the second process conditions, an n-type well region N11' corresponds to the n-type well region N11, a p-type well region P12' corresponds to the p-type well region P12, and a first substrate P11' corresponds to the first substrate P11. In some example embodiments, the second process conditions may involve a BSPDN, and in this case, a portion P11" of the first substrate P11' may be removed, e.g., etched-back and/or polished back, so as to enable power delivery from a back side of the first substrate P11'. Thus, referring to the cross-sectional diagram of the integrated circuit included in the second die having the second process conditions, it may be physically impossible to implement a BJT element B1'. In some example embodiments, the thickness D1 of the first substrate P11 of the first die having the first process conditions may be greater than the thickness D2 of the first substrate P11' of the second die having the second process conditions. In some example embodiments, not all the second process conditions may involve a BSPDN design, but some of the second process conditions may require or may use a BSPDN design

According to some example embodiments, when it is not possible to physically implement a BJT element and a reference voltage and current generation circuit including a BJT element in the second die having the second process conditions because the second process conditions involve a BSPDN, a reference voltage and current generation circuit including a BJT element may be implemented under the first process conditions different from the second process conditions, and operations may be performed based on reference values received from the reference voltage and current generation circuit, thereby ensuring easy circuit designs.

FIG. 5 is a circuit diagram illustrating a device including a first die and a second die according to some example embodiments.

Referring to FIG. 5, a semiconductor device 400 may include a reference voltage generation circuit 411, a second die 420, and a channel 430. For ease of illustration, a first die including the reference voltage generation circuit 411 is not illustrated.

The reference voltage generation circuit 411 shown in FIG. 5 may include a BGR circuit. The reference voltage generation circuit 411 may generate a reference voltage V_{REF} having a stable or more stable level independent of, for example, process, voltage, and temperature (PVT) variations. The reference voltage generation circuit 411 may include an operational amplifier OPAMP, first to third PMOS transistors P1, P2, and P3, third to sixth resistors R3, R4, R5, and R6, a first BJT Q1, and a second BJT Q2. The size of the second BJT Q2 may be N times the size of the first BJT Q1. N my refer to a natural number greater than or equal to 1.

The first PMOS transistor P1 may be connected between a supply voltage AVDD and a first input terminal (-) of the operational amplifier OPAMP and may include a gate connected to an output terminal of the operational amplifier OPAMP. The second PMOS transistor P2 may be connected between the supply voltage AVDD and a second input terminal (+) of the operational amplifier OPAMP and may include a gate connected to the output terminal of the operational amplifier OPAMP. The third PMOS transistor P3 may be connected between the supply voltage AVDD and an output terminal OUT and may include a gate connected to the output terminal of the operational amplifier OPAMP.

The gates of the first PMOS transistor P1, the second PMOS transistor P2, and the third PMOS transistor P3 may be commonly connected to the output terminal of the operational amplifier OPAMP. The sizes of, e.g., the gate widths of, the first and second PMOS transistors P1 and P2 may be identical, and the ratio of the size of the second PMOS transistor P2 and the size of the third PMOS transistor P3 may be 1:M. M may refer to a number such as a natural number greater than or equal to 1.

The third resistor R3 may be connected between the first input terminal (-) of the operational amplifier OPAMP and ground, and the first BJT Q1 may be connected between the first input terminal (-) of the operational amplifier OPAMP and the ground. The fourth resistor R4 and the second BJT Q2 may be connected in series to each other between the second input terminal (+) of the operational amplifier OPAMP and the ground. The fifth resistor R5 may be connected between the second input terminal (+) of the operational amplifier OPAMP and the ground, and the sixth resistor R6 may be connected between the output terminal OUT and the ground. Because the first and second PMOS transistors P1 and P2 have the same size (e.g., the same gate width) and gates commonly connected to the output terminal of the operational amplifier OPAMP, a first current I1 flowing through the first PMOS transistor P1 and a second current I2 flowing through the second PMOS transistor P2 may be substantially the same.

Turn-on levels of or threshold voltage levels of the first and second PMOS transistors P1 and P2 may vary according to an output voltage of the operational amplifier OPAMP. Depending on this, the first current I1 and the second current I2 may be adjusted. This operation continues until the level of voltage VN applied to the first input terminal (-) of the operational amplifier OPAMP becomes equal to the level of voltage VP applied to the second input terminal (+) of the operational amplifier OPAMP.

The voltage VN applied to the first input terminal (-) of the operational amplifier OPAMP may be inversely proportional to temperature due to a complementary-to-absolute-temperature (CTAT) characteristic of a base-emitter voltage VBE of the first BJT Q1. Because the voltage VP applied to the second input terminal (+) of the operational amplifier OPAMP is equal to the voltage VN applied to the first input terminal (-) of the operational amplifier OPAMP, current flowing through the fifth resistor R5 may be reverse proportional to absolute temperature.

A base-emitter voltage VBEN of the second BJT Q2 also decreases with rising temperature. Because the size of the second BJT Q2 is N times the size of the first BJT Q1, temperature-related variations of the base-emitter voltage VBEN of the second BJT Q2 are greater than temperature-related variations of the base-emitter voltage VBE of the first BJT Q1. As a result, a voltage difference between both ends of the fourth resistor R4 may increase as temperature increases, Thus, current flowing through the fourth resistor R4 may be proportional to an absolute temperature. A proportional-to-absolute-temperature (PTAT) characteristic of current flowing through the fourth resistor R4 may be offset by a CTAT characteristic of current flowing through the fifth resistor R5.

When the ratio of the size of, e.g., gate width of the second PMOS transistor P2 and the size of the third PMOS transistor P3 is 1:M, the amount of current I3 flowing through the third PMOS transistor P3 may be M times the amount of current I2 flowing through the second PMOS transistor P2. When the level of voltage VN applied to the first input terminal (-) of the operational amplifier OPAMP is equal to the level of voltage VP applied to the second input terminal (+) of the operational amplifier OPAMP, a reference voltage V_{REF} having a constant level may be applied to the output terminal OUT.

As described above, a reference voltage V_{REF} may be generated through the first BJT Q1 and the second BJT Q2 of the reference voltage generation circuit 411 and may be provided to a second internal circuit 421 of the second die 420 through the channel 430. For example, a reference voltage V_{REF} may be generated by the reference voltage generation circuit 411 of the first die and provided to the second internal circuit 421 of the second die 420, and thus, the second internal circuit 421 may be controlled to operate based on the reference voltage V_{REF}. In another example, when the second internal circuit 421 of the second die 420 is required to operate based on a reference current, the second die 420 may further include a V-I converter to convert received reference voltage into a reference current.

According to some example embodiments, the reference voltage generation circuit 411 may be formed in the first die to simplify circuit implementation and may eliminate or reduce the need or desire for high supply voltages in the second die 420.

FIG. 6 is a circuit diagram illustrating a device including a first die and a second die according to some example embodiments.

Referring to FIG. 6, a semiconductor device 500 may include a reference current generation circuit 511, a second die 520, and a channel 530. For ease of illustration, a first die including the reference current generation circuit 511 is not illustrated.

The reference current generation circuit 511 shown in FIG. 6 may include a BGR circuit. The reference current generation circuit 511 may generate a reference current I_{REF} having a stable level independent of PVT variations. The reference current generation circuit 511 may include an operational amplifier OPAMP, first to third PMOS transistors P1, P2, and P3, third to fifth resistors R3, R4, and R5, a first BJT Q1, and a second BJT Q2. Descriptions of operations of the reference current generation circuit 511 that are substantially the same as the operations of the reference voltage generation circuit 411 described with reference to FIG. 5 are omitted.

The reference current generation circuit 511 shown in FIG. 6 may be different from the reference voltage generation circuit 411 shown in FIG. 5 in that the reference current generation circuit 511 does not include a sixth resistor R6. The reference current generation circuit 511, which is implemented in the first die having first process conditions based on the operational principle of a BGR circuit, may generate a current IPTAT that increases with temperature and a current ICTAT that decreases with temperature. The current IPTAT that increases with temperature and the current ICTAT that decreases with temperature are generated by the same transistor, and thus, a current flowing through the transistor may be IPTAT + ICTAT and may remain constant regardless of temperature. The current flowing through the transistor may be copied and applied to the second die 520 through the channel 530. In some example embodiments, the third PMOS transistor P3 may output the reference current I_{REF}, and the reference current I_{REF} may be provided to a second internal circuit 521 of the second die 520 through the channel 530. In some example embodiments, when the second internal circuit 521 is configured to operate based on a reference current, the second internal circuit 521 may operate by directly receiving the reference current I_{REF} provided through the channel 530. In some example embodiments, when the second internal circuit 521 is configured to operate based on a reference voltage, the reference current I_{REF} provided through the channel 530 may be converted into a reference voltage V_{REF} by a second conversion circuit 522, and the reference voltage V_{REF} may be provided to the second internal circuit 521. In some example embodiments, the second conversion circuit 522 may include the resistor R6. In some example embodiments, some example embodiments in which the second conversion circuit 522 includes only one resistor R6 is illustrated as an example. However, the configuration of the second conversion circuit 522 is not limited thereto.

Although BGR circuits are described with reference to FIGS. 5 and 6 as examples of a reference generation circuit, example embodiments are not limited thereto. Some components of a reference generation circuit may be modified as long as the reference generation circuit includes a BJT element.

According to some example embodiments, a reference voltage or a reference current generated in a first die using a BGR circuit as a reference voltage generation circuit or a reference current generation circuit may be provided to a second die through a channel. For example, a BGR circuit that generates a reference current or a reference voltage may be implemented in the first die, and thus, a highly accurate BJT element may be used. Furthermore, complex tolerant design techniques are not used for a second die, thereby reducing design costs and generating a precise reference current or reference voltage.

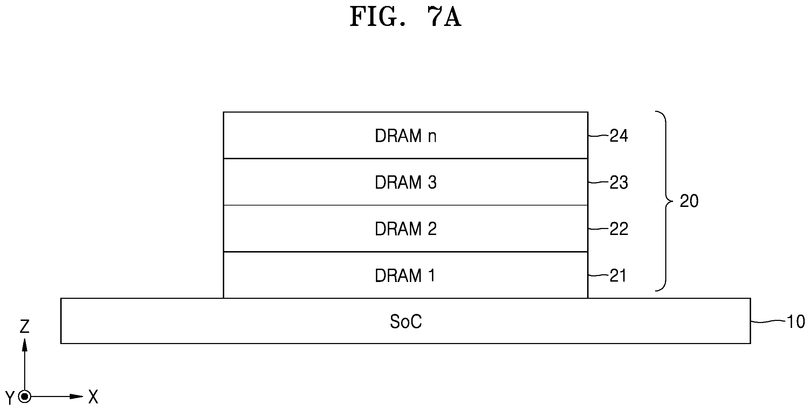

FIG. 7A is a schematic diagram illustrating a die arrangement structure according to some example embodiments.

FIG. 7A illustrates a stacked-type arrangement structure including a system-on-chip SoC 10 as a controller and a high bandwidth memory (HBM) 20 having a stacked device structure. The HBM 20 may include a plurality of first, second, third and nth memory dies 21, 22, 23, and 24 operating in a multi-rank configuration. Referring to FIG. 7A, the first, second, third and nth memory dies 21, 22, 23, and 24 may be stacked on an upper portion of the SoC 10 and may be implemented having a package-on-package (PoP) structure or as a single package.

Each of the first, second, third and nth memory dies 21, 22, 23, and 24 may have the same, or different, characteristics. For example, each of the first, second, third and nth memory dies 21, 22, 23, and 24 may have the same, or different, capacity and/or operational speed and/or size and/or operating voltages. Example embodiments are not limited thereto.

For example, when the SoC 10 is positioned in a first layer, the first memory die 21 may be positioned in a second layer. Although FIG. 7A illustrates that the second memory die 22 is positioned on an upper portion of the first memory die 21, the first memory die 21 may instead be positioned on an upper portion of the second memory die 22 or the nth memory die 24.

HBM or stacked device structures are capable of providing high performance, such as high-capacity and high-speed operations, and are thus gaining attention. HBM is or includes a type of memory structure in which a plurality of memory dies are stacked on a buffer die (or base die) that functions as a logic circuit at a lower side. Here, the buffer die and the memory dies may be connected to each other through TSVs for data and control signal communication.

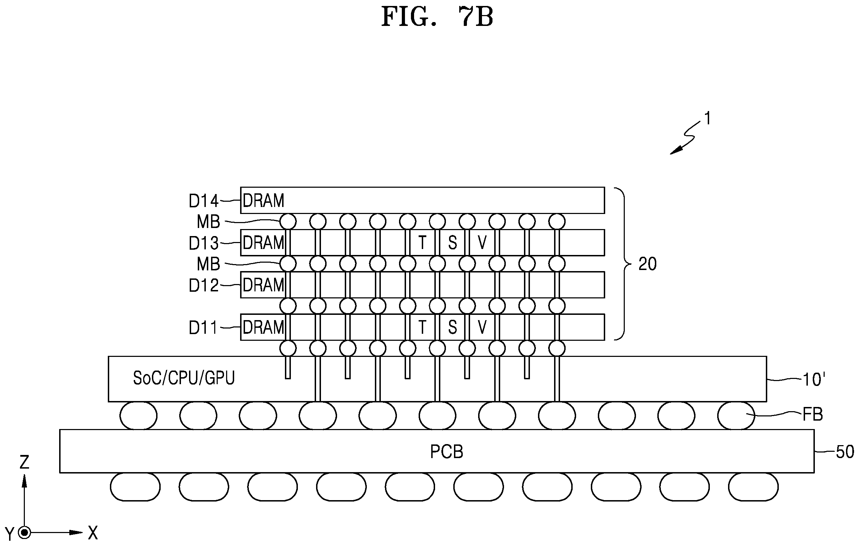

FIG. 7B is a block diagram illustrating a 3D device structure to which the die arrangement structure shown in FIG. 7A is applied.

FIG. 7B illustrates a 3D device structure 1 in which a host and an HBM are directly connected to each other without an interposer layer. Referring to FIG. 7B, a host die 10' that may be an SoC, a central processing unit (CPU), or a graphics processing unit (GPU). The host die 10' may be disposed on an upper portion of a printed circuit board (PCB) 50 through flip device bumps FB. Memory dies D11 to D14 may be stacked above the host die 10' to form an HBM 20. Although FIG. 7B does not illustrate a buffer die or logic die, a buffer die or logic die may be positioned between the memory die D11 and the host die 10'. TSV lines, referred to as TSVs, may be formed in the memory dies D11 to D14 to implement the HBM 20. The TSV lines may be electrically connected to micro-bumps MB formed between the memory dies D11 to D14.

The structures shown in FIGS. 7A and 7B may be 3D device structures. The 3D device structures may each refer to a structure in which an HBM is positioned above a host to directly connect the host and the HBM to each other in a vertical direction. According to some example embodiments, the first and second dies may be applied to the memory dies of the HBM 20, the buffer die, or the host die 10' described with reference to FIG. 7A or 7B. This is further described with reference to FIG. 9A to 10B.

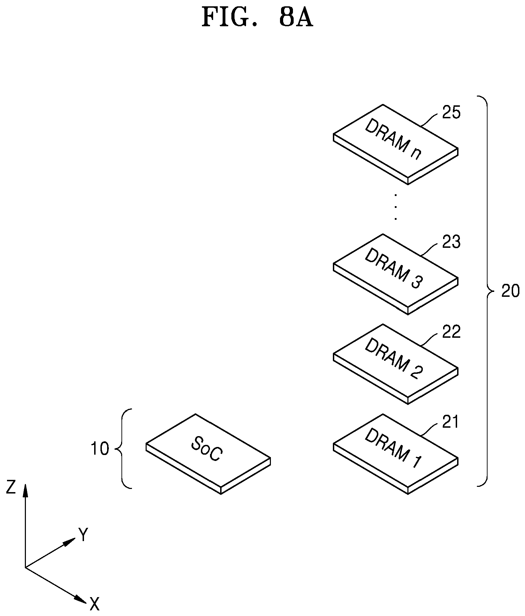

FIG. 8A is a schematic diagram illustrating a die arrangement structure according to some example embodiments.

FIG. 8A illustrates an arrangement structure including an SoC 10 functioning as a controller and an HBM 20 having a stacked device structure. The HBM 20 may include a plurality of first, second, third, ... and nth memory dies 21, 22, 23, ..., and 25 operating in a multi-rank configuration. The HBM 20 may have a dual-rank structure with two memory dies. However, FIG. 8A illustrates an example in which the HBM 20 has a multi-rank structure with at least three memory dies.

Referring to FIG. 8A, the SoC 10 and the first memory die 21 may be positioned in the same layer on a substrate. For instance, when the SoC 10 is positioned in a first layer, the first memory die 21 may also be positioned in the first layer. Although FIG. 8A illustrates that the second memory die 22 is placed above the first memory die 21, the first memory die 21 may instead be placed above the second memory die 22.

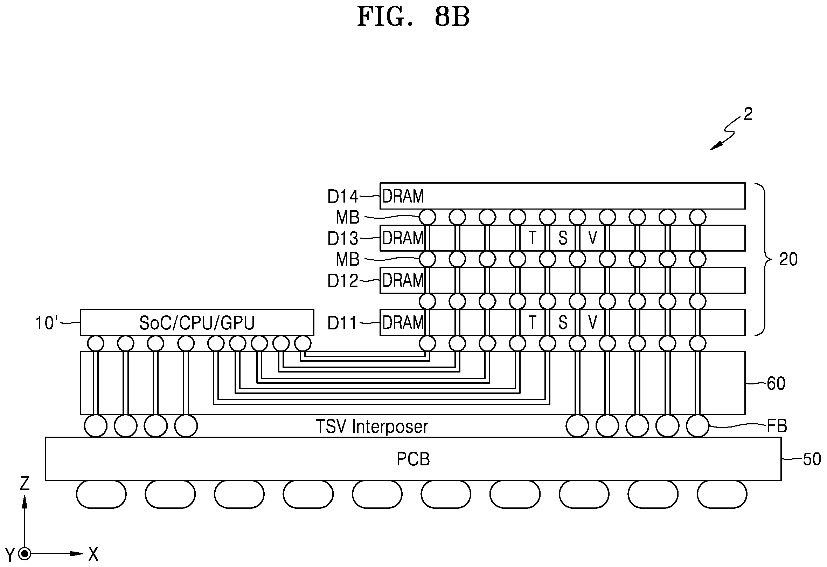

FIG. 8B is a block diagram illustrating a 2.5D device structure 2 to which the die arrangement structure shown in FIG. 8A is applied.

Referring to FIG. 8B, in the 2.5D device structure 2, an HBM 20 and a host die 10' are connected to each other using an interposer layer 60 instead of a PCB 50. The interposer layer 60 may be disposed above the PCB 50 and electrically connected to the PCB 50 via flip device bumps FB. The host die 10' and memory dies D11 to D14 forming the HBM 20 may be arranged above the interposer layer 60. Although FIG. 8B does not illustrate a buffer die or a logic die, a buffer die or a logic die may be disposed between the memory die D11 and the interposer layer 60. TSV lines may be formed in the memory dies D11 to D14 to implement the HBM 20. The TSV lines may be electrically connected to micro-bumps MB formed between the memory dies D11 to D14.

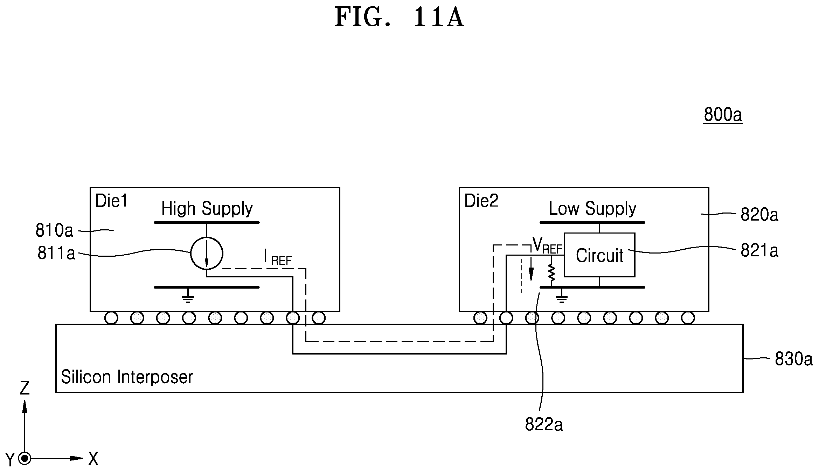

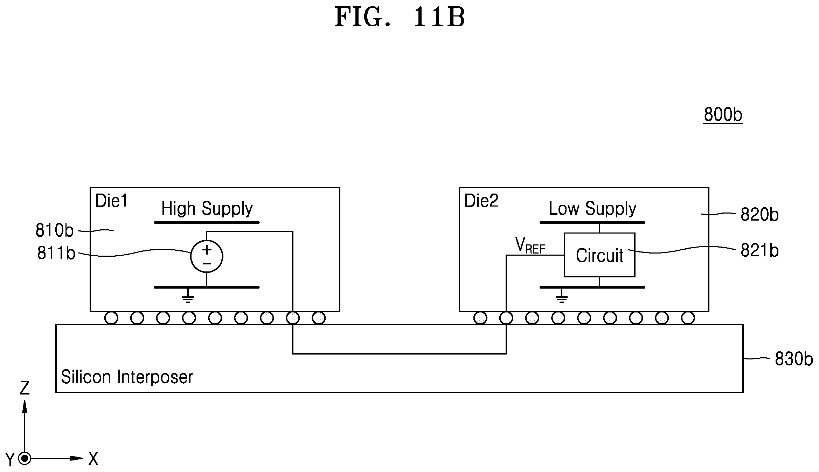

FIG. 8B illustrates the 2.5D device structure 2 employing the interposer layer 60. The 2.5D device structure may refer to a structure employing an interposer instead of a PCB to electrically connect the HBM 20 and the host die 10' to each other. According to some example embodiments, the first and second dies may correspond to the host die 10', the memory dies D11 to D14 of the HBM 20, or the buffer die described with reference to FIG. 8B. This is further described with reference to FIGS. 11A and 11B.

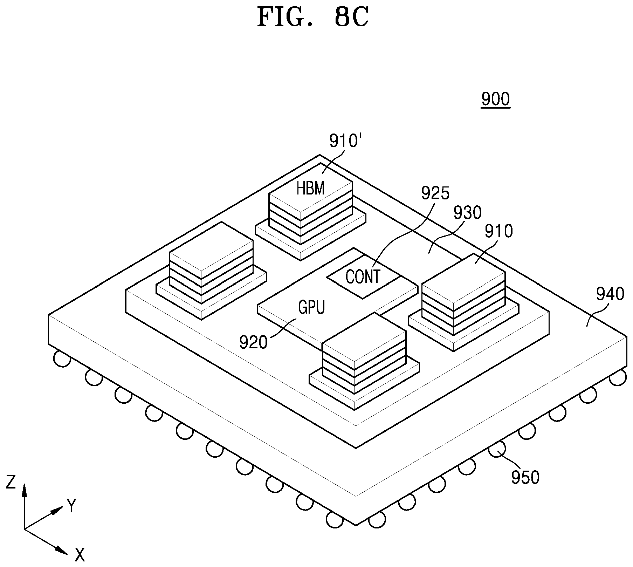

FIG. 8C is a structural diagram illustrating an example of a semiconductor package 900 to which the 2.5D device structure 2 shown in FIG. 8B is applied.

Referring to FIG. 8C, the semiconductor package 900 may include at least one stacked-type memory device 910 and a GPU 920, and the GPU 920 may include a memory controller 925.

The at least one stacked-type memory devices 910 and the GPU 920 may be mounted on an interposer 930, and the interposer 930 on which the at least one stacked-type memory devices 910 and the GPU 920 are mounted may be mounted on a package substrate 940.

The at least one stacked-type memory device 910 may be implemented in various forms. In some example embodiments, the at least one stacked-type memory device 910 may be an HBM device including a plurality of layers stacked together. Therefore, the at least one stacked-type memory device 910 may include a buffer die and a plurality of memory dies, and each of the memory dies may include a memory cell array and an integrated circuit.

A plurality of stacked-type memory devices 910 may be mounted on the interposer 930, and the GPU 920 may communicate with the stacked-type memory devices 910. For instance, each of the stacked-type memory devices 910 and the GPU 920 may include physical regions, and the stacked-type memory devices 910 and the GPU 920 may communicate with each other through the physical regions.

According to some example embodiments, the first and second dies of some example embodiments may correspond to a die corresponding to the GPU 920 and the dies included in the at least one stacked-type memory device 910 described with reference to FIG. 8C. In some example embodiments, the first and second dies may respectively correspond to a die included in one of the at least one stacked-type memory device 910 shown in FIG. 8C and a die included in another stacked-type memory device 910' shown in FIG. 8C.

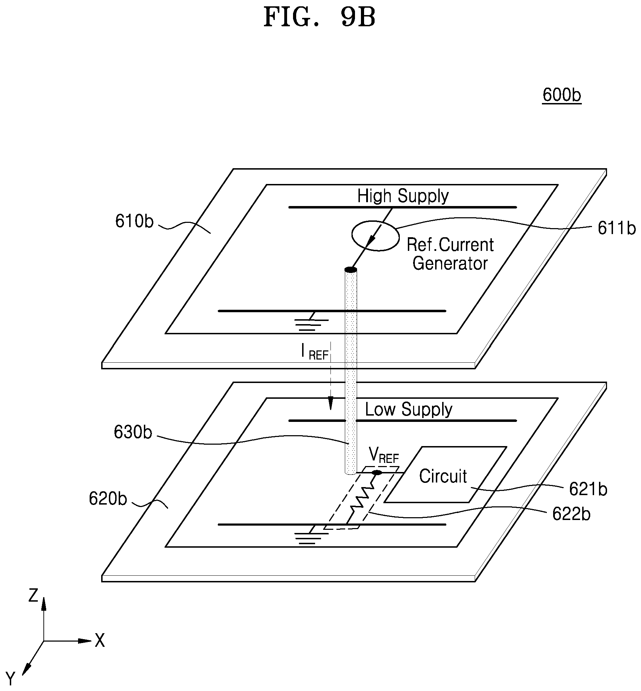

FIGS. 9A and 9B are diagrams illustrating embodiments in which first and second dies are applied to the 3D device structure shown in FIG. 7B.

Referring to FIG. 9A, a semiconductor device 600a may include a first die 610a, a second die 620a, and a channel 630a. The first die 610a and the second die 620a may be stacked vertically. In some example embodiments, the first die 610a is positioned below the second die 620a. In some example embodiments, the first die 610a and the second die 620a may be applied to the 3D device structure (stacked-type arrangement structure) described with reference to FIGS. 7A and 7B. In some example embodiments, each of the first die 610A and the second die 620a may correspond to the host die 10' or one of the memory dies D11 to D14 described with reference to FIG. 7B.

The first die 610a may be manufactured under first process conditions, and the second die 620a may be manufactured under second process conditions. The first process conditions may refer to legacy process conditions, and the second process conditions may refer to process conditions for manufacturing transistors having a line width of less than 3 nm.

In some example embodiments, the first die 610a may include a reference current generation circuit (ref. current generator) 611a, and a reference current I_{REF} generated by the reference current generation circuit 611a may be provided to a second internal circuit 621a of the second die 620a through the channel 630a. In some example embodiments, the channel 630a may include a TSV.

Referring to the example shown in FIG. 9A, when the second die 620a requires a reference current, the reference current I_{REF} provided from the first die 610a to the second die 620a may be directly provided to the second internal circuit 621a without converting. Referring to the example shown in FIG. 9A, when the second die 620a requires a reference voltage, the reference current I_{REF} provided from the first die 610a to the second die 620a may be converted into a reference voltage V_{REF} by a conversion circuit 622a, and then, the reference voltage V_{REF} may be provided to the second internal circuit 621a. In some example embodiments, the conversion circuit 622a may include a resistor, and the reference voltage V_{REF} may be generated by applying the reference current I_{REF} to the resistor. In this case, because the reference current I_{REF} is provided, the reference voltage V_{REF} is independent of a supply voltage used under the second process conditions of the second die 620a. Thus, a high supply voltage may not be required in an advanced process. In addition, because the reference voltage V_{REF} is generated using the resistor in the second die 620a, there may be no effect of current-resistance (IR)-drop between the first die 610a and the second die 620a. In some example embodiments, providing a reference current eliminates an effect of IR drop, thereby reducing voltage distortion and/or improving accuracy.

Referring to FIG. 9B, a semiconductor device 600b may include a first die 610b, a second die 620b, and a channel 630b. The first die 610b and the second die 620b may be stacked vertically. In some example embodiments, the first die 610b may be positioned above the second die 620b. In some example embodiments, the first die 610b and the second die 620b may be applied to the 3D device structure (stacked-type arrangement structure) described with reference to FIGS. 7A and 7B. In some example embodiments, the first dies 610a and 610b manufactured in a legacy process may be disposed above or below the second dies 620a and 620b manufactured in a miniaturized process.

The first die 610b, the second die 620b, and the channel 630b correspond to the first die 610a, the second die 620a, and the channel 630a described with reference to FIG. 9A except for an arrangement structure of the first die 610b and the second die 620b, and thus, repeated descriptions thereof are omitted.

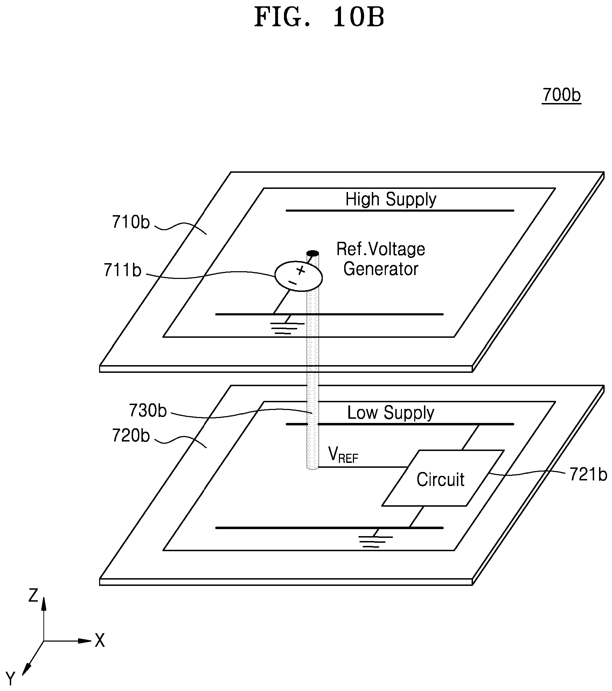

FIGS. 10A and 10B are diagrams illustrating embodiments in which first and second dies are applied to the 3D device structure shown in FIG. 7B.

Referring to FIG. 10A, a semiconductor device 700a may include a first die 710a, a second die 720a, and a channel 730a. The first die 710a and the second die 720a may be stacked vertically. In some example embodiments, the first die 710a may be positioned below the second die 720a. In some example embodiments, the first die 710a and the second die 720a may be applied to the 3D device structure (stacked-type arrangement structure) described with reference to FIGS. 7A and 7B. In some example embodiments, each of the first die 710a and the second die 720a may correspond to the host die 10' or one of the memory dies D11 to D14 described with reference to FIG. 7B.

The first die 710a may be manufactured under first process conditions, and the second die 720a may be manufactured under second process conditions. The first process conditions may refer to legacy process conditions, and the second process conditions may refer to process conditions for manufacturing transistors having a line width of less than 3 nm.

In some example embodiments, the first die 710a may include a reference voltage generation circuit (ref. voltage generator) 711a, and a reference voltage V_{REF} generated by the reference voltage generation circuit 711a may be provided to a second internal circuit 721a of the second die 720a through the channel 730a. In some example embodiments, the channel 730a may include a TSV.

Referring to the example shown in FIG. 10A, when the second die 720a requires a reference voltage, the reference voltage V_{REF} provided from the first die 710a to the second die 720a may be directly provided to the second internal circuit 721a without converting. In some example embodiments, when the second die 720a requires a reference current, the reference current may be generated using a V-I converter that may be connected between the second internal circuit 721a and the channel 730a of the second die 720a. In some example embodiments, applying a reference voltage as described above may have a positive effect in terms of impedance.

Referring to FIG. 10B, a semiconductor device 700b may include a first die 710b, a second die 720b, and a channel 730b. The first die 710b and the second die 720b may be stacked vertically. In some example embodiments, the first die 710b may be positioned above the second die 720b. In some example embodiments, the first die 710b and the second die 720b may be applied to the 3D device structure (stacked-type arrangement structure) described with reference to FIGS. 7A and 7B. In some example embodiments, the first dies 710a and 710b manufactured in a legacy process may be disposed above or below the second dies 720a and 720b manufactured in a miniaturized process.

The first die 710b, the second die 720b, and the channel 730b correspond to the first die 710a, the second die 720a, and the channel 730a described with reference to FIG. 10A except for an arrangement structure of the first die 710b and the second die 720b, and thus, repeated descriptions thereof are omitted.

FIGS. 11A and 11B are diagrams illustrating embodiments in which first and second dies are applied to the 2.5D device structure shown in FIG. 8B.

Referring to FIG. 11A, a semiconductor device 800a may include a first die 810a, a second die 820a, and a channel 830a. The first die 810A and the second die 820a may be arranged horizontally. In some example embodiments, the first die 810a and the second die 820a may be positioned on the same plane. In some example embodiments, the first die 810a and the second die 820a may be applied to the 2.5D device structure described with reference to FIGS. 8A to 8C. In some example embodiments, each of the first die 810a and the second die 820a may correspond to the host die 10' or one of the memory dies D11 to D14 of FIGS. 8B.

The first die 810a may be manufactured under first process conditions, and the second die 820a may be manufactured under second process conditions. The first process conditions may refer to legacy process conditions, and the second process conditions may refer to process conditions for manufacturing transistors having a line width of less than 3 nm.

In some example embodiments, the first die 810a may include a reference current generation circuit 811a, and a reference current I_{REF} generated by the reference current generation circuit 811a may be provided to a second internal circuit 821a of the second die 820a through the channel 830a. The channel 830a may include an interposer layer.

Referring to the example shown in FIG. 11A, when the second die 820a requires a reference current, the reference current I_{REF} provided from the first die 810a to the second die 820a may be directly provided to the second internal circuit 821a without converting. Referring to the example shown in FIG. 11A, when the second die 820a requires a reference voltage, the reference current I_{REF} provided from the first die 810a to the second die 820a may be converted into a reference voltage V_{REF} by a conversion circuit 822a, and then, the reference voltage V_{REF} may be provided to the second internal circuit 821a. In some example embodiments, the conversion circuit 822a may include a resistor, and the reference voltage V_{REF} may be generated by applying the reference current I_{REF} to the resistor. In this case, because the reference current I_{REF} is provided, the reference voltage V_{REF} is independent of a supply voltage used under the second process conditions of the second die 820a. Thus, a high supply voltage may not be required in an advanced process, thereby improving effectiveness. In addition, because the reference voltage V_{REF} is generated using the resistor in the second die 820a, there may be no effect of IR-drop between the first die 810a and the second die 820a.

Referring to FIG. 11B, a semiconductor device 800b may include a first die 810b, a second die 820b, and a channel 830b. The first die 810B and the second die 820b may be arranged horizontally. In some example embodiments, the first die 810b and the second die 820b may be applied to the 2.5D device structure described with reference to FIGS. 8A to 8C.

Process conditions for the first die 810b and the second die 820b shown in FIG. 11B may correspond to the process conditions for the first die 810a and the second die 820a shown in FIG. 11A, and thus, repeated descriptions thereof are omitted.

In some example embodiments, the first die 810b may include a reference voltage generation circuit 811b, and a reference voltage V_{REF} generated by the reference voltage generation circuit 811b may be provided to a second internal circuit 821b of the second die 820b through the channel 830b. In some example embodiments, the channel 830b may include an interposer layer.

Referring to the example shown in FIG. 11B, when the second die 820b requires a reference voltage, the reference voltage V_{REF} provided from the first die 810b to the second die 820b may be directly provided to the second internal circuit 821b without converting the reference voltage V_{REF}. In some example embodiments, when the second die 820b requires a reference current, the reference current may be generated using a V-I converter that may be connected between the second internal circuit 821b of the second die 820b and the channel 830b.

Some example embodiments provide a semiconductor device having a 3D or 2.5D chiplet structure with two or more dies, in which a reference current or a reference voltage is generated using a BJT element of a die manufactured under legacy process conditions, and the reference current or the reference voltage is provided through a channel to a die manufactured under miniaturized process conditions. According to some example embodiments, the need to design a reference voltage/current circuit in a die having miniaturized process conditions is eliminated, and thus, the die having miniaturized process conditions may be efficient in terms of area, power, and design costs and may receive precise reference voltage and current.

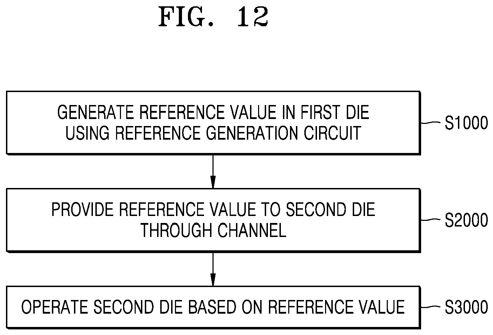

FIG. 12 is a flowchart illustrating a method of providing a reference value according to some example embodiments.

In operation S1000, a reference value may be generated by a reference generation circuit in a first die. In some example embodiments, the first die may have first process conditions. In some example embodiments, the reference generation circuit may include a BGR circuit. The reference generation circuit may include a BJT element.

In operation S2000, the reference value may be provided to a second die through a channel. In some example embodiments, when a package structure of a semiconductor device including the first die and the second die is a 3D structure, the channel may include a TSV. In another example, when a package structure of a semiconductor device including the first die and the second die is a 2.5D structure, the channel may include an interposer layer.

In operation S3000, the second die may be operated based on the reference value. In some example embodiments, the second die may include an internal circuit, and the internal circuit may be operated based on the reference value. In some example embodiments, the reference value may be used directly or converted before use.

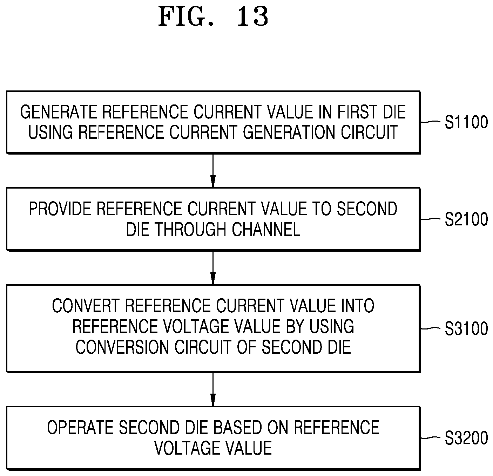

FIG. 13 is a flowchart illustrating a method of providing a reference current value according to some example embodiments.

In operation S1100, a reference current value may be generated by a reference current generation circuit in a first die.

In operation S2100, the reference current value may be provided to a second die through a channel. The channel may be may include a TSV or an interposer layer.

In operation S3100, the reference current value may be converted into a reference voltage value by using a conversion circuit of the second die. In some example embodiments, when the second die requires a reference voltage value even though the second die receives a reference current value, the reference current value may be converted using the conversion circuit. The conversion circuit may include a resistor. In this case, the reference voltage value is independent of supply voltage of the second die, and thus, it may not be required to apply high supply voltage to the second die. In addition, because reference current is applied, reference voltage is not affected by an IR drop of the channel.

In operation S3200, the second die may be operated based on the reference voltage value obtained by conversion.

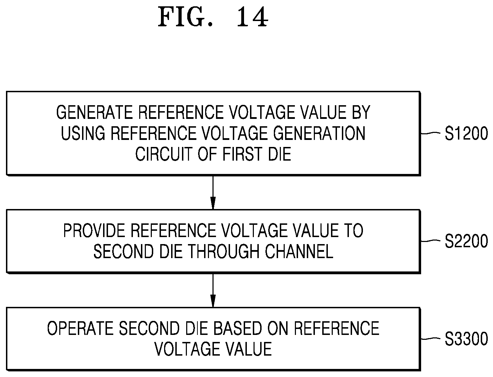

FIG. 14 is a flowchart illustrating a method of providing a reference voltage value according to some example embodiments.

In operation S1200, a reference voltage value may be generated by a reference voltage generation circuit in a first die.

In operation S2200, the reference voltage value may be provided to a second die through a channel. The channel may include a TSV or an interposer layer.

In operation S3300, the second die may be operated based on the reference voltage value. In this case, because the reference voltage value is applied to the second die, the second die may be operated based on the reference voltage value without conversion. In another example, when the second die is configured to operate based on a reference current value, the method may further include an operation of converting the reference voltage value into the reference current value.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While some example embodiments have been particularly shown and described with reference to embodiments thereof, it will be understood that various changes in form and details may be made therein without departing from the scope of the following claims. Additionally, example embodiments are not necessarily mutually exclusive with one another. For example, some example embodiments may include one or more features described with reference to one or more figures, and may also include one or more other features described with reference to one or more other figures.

Embodiments and examples of the invention may be exemplified by the following numbered clauses:
Clause 1. A semiconductor device comprising:
   a first die having a first structure; and
   a second die having a second structure,
   wherein the first die comprises a reference generation circuit comprising a bipolar junction transistor (BJT) element,
   the second die is configured to operate based on a reference value generated by the reference generation circuit, and
   the first structure is different from the second structure.
Clause 2. The semiconductor device of clause 1, wherein the reference generation circuit comprises a band gap reference circuit.
Clause 3. The semiconductor device of clause 1, wherein the reference generation circuit comprises at least one of a reference voltage generation circuit or a reference current generation circuit.
Clause 4. The semiconductor device of clause 1, further comprising:
   a channel configured to provide the reference value generated by the reference generation circuit,
   wherein the channel is connected between the first die and the second die.
Clause 5. The semiconductor device of clause 4, wherein the channel comprises a through-silicon via (TSV).
Clause 6. The semiconductor device of clause 4, wherein the channel comprises an interposer layer.
Clause 7. The semiconductor device of clause 1, wherein
   the first die does not include a transistor having a line width of less than 3 nm, and
   the second die includes a transistor having a line width of less than 3 nm.
Clause 8. The semiconductor device of clause 1, wherein a thickness of a substrate included in the first die is greater than a thickness of a substrate included in the second die.
Clause 9. A semiconductor device comprising a first die and a second die that are stacked in a vertical direction,
   wherein the first die comprises a reference generation circuit comprising a bipolar junction transistor (BJT) element,
   the second die is configured to operate based on a reference value generated by the reference generation circuit, and
   the second die includes a transistor having a line width of less than 3 nm.
Clause 10. The semiconductor device of clause 9, wherein the reference generation circuit comprises a band gap reference circuit.
Clause 11. The semiconductor device of clause 9, wherein
   the reference generation circuit comprises a reference voltage generation circuit, and
   the second die comprises an internal circuit configured to operate based on the reference value.
Clause 12. The semiconductor device of clause 9, wherein
   the reference generation circuit comprises a reference current generation circuit, and
   the second die comprises:
      a conversion circuit configured to convert the reference value; and
      an internal circuit configured to operate based on a value generated by the conversion circuit.
Clause 13. The semiconductor device of clause 9, further comprising:
   a channel connecting the first die and the second die to each other,
   wherein the channel comprises a through-silicon via (TSV).
Clause 14. The semiconductor device of clause 9, wherein the first die is below the second die.
Clause 15. The semiconductor device of clause 9, wherein the first die is above the second die.

## Claims

1. A semiconductor device (100) comprising:
a first die (110) having a first structure; and
a second die (120) having a second structure,
wherein the first die (110) comprises a reference generation circuit (111) comprising a bipolar junction transistor, BJT, element (B1),
the second die (120) is configured to operate based on a reference value generated by the reference generation circuit (111), and
the first structure is different from the second structure.

2. The semiconductor device (100) of claim 1, wherein the reference generation circuit (111) comprises a band gap reference circuit.

3. The semiconductor device (100) of any preceding claim, further comprising:
a channel (130) configured to provide the reference value generated by the reference generation circuit (111),
wherein the channel (130) is connected between the first die (110) and the second die (130).

4. The semiconductor device (100) of claim 3, wherein the channel (130) comprises a through-silicon via, TSV.

5. The semiconductor device (100) of claim 3, wherein the channel (130) comprises an interposer layer (60).

6. The semiconductor device (100) of any preceding claim, wherein
the first die (110) does not include a transistor having a line width of less than 3 nm.

7. The semiconductor device (100) of any preceding claim, wherein
the second die (120) includes a transistor having a line width of less than 3 nm.

8. The semiconductor device (100) of any preceding claim, wherein a thickness of a substrate (P11) included in the first die (110) is greater than a thickness of a substrate (P11') included in the second die (120).

9. The semiconductor device (100) of any preceding claim, wherein the reference generation circuit (111) comprises at least one of a reference voltage generation circuit (211) or a reference current generation circuit (311).

10. The semiconductor device (100) of claim 9, wherein
the reference generation circuit (111) comprises a reference voltage generation circuit (211), and
the second die (120) comprises an internal circuit (221) configured to operate based on the reference value.

11. The semiconductor device (100) of claim 9, wherein
the reference generation circuit (111) comprises a reference current generation circuit (311), and
the second die (120) comprises:
a conversion circuit (322) configured to convert the reference value; and
an internal circuit (321) configured to operate based on a value generated by the conversion circuit (322).

12. The semiconductor device (100) of any preceding claim, wherein the first die (110) and the second die (120) are stacked in a vertical direction.

13. The semiconductor device (100) of claim 12, wherein the first die (110) is below the second die (120).

14. The semiconductor device of claim 12, wherein the first die (110) is above the second die (120).
